(19) Europäisches Patentamt / European Patent Office / Office européen des brevets

(11) **EP 2 172 785 B1**

(12) **FASCICULE DE BREVET EUROPEEN**

(45) Date de publication et mention de la délivrance du brevet:
**16.03.2016 Bulletin 2016/11**

(51) Int Cl.:
*G01R 23/10* *(2006.01)*   *G05B 19/05* *(2006.01)*

(21) Numéro de dépôt: **09171379.2**

(22) Date de dépôt: **25.09.2009**

(54) **Dispositif et procédé de mesure de fréquence dans un module automate**

Vorrichtung und Verfahren zur Frequenzmessung im Automatisierungsmodul

Device and method for measuring frequency in an automation module

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **01.10.2008 FR 0856637**

(43) Date de publication de la demande:
**07.04.2010 Bulletin 2010/14**

(73) Titulaire: **Schneider Electric Industries SAS 92500 Rueil-Malmaison (FR)**

(72) Inventeurs:
• **Gomez, Gérard**
  **06150, LE BROC (FR)**
• **Vert, Thierry**
  **06130, GRASSE (FR)**

(74) Mandataire: **Dufresne, Thierry et al Schneider Electric Industries SAS Service Propriété Industrielle 35 rue Joseph Monier - CS 30323 92506 Rueil-Malmaison Cedex (FR)**

(56) Documents cités:
**WO-A1-2006/040699    WO-A2-02/099443**
**US-A- 3 982 109    US-A- 4 958 362**
**US-A- 5 027 046**

EP 2 172 785 B1

**Description**

La présente invention se rapporte à un dispositif et un procédé de mesure pouvant être employés dans un équipement d'automatisme tel qu'un module d'entrées/sorties d'un automate programmable.

Un automate programmable ou PLC ("Programmable Logical Controller") est un équipement d'automatisme capable de piloter, commander et/ou surveiller un ou plusieurs process à automatiser. De construction généralement modulaire, un automate programmable PLC est composé de différents modulés qui communiquent entre eux par un bus de transmission, qui peut être notamment le bus dit «fond de panier» (ou «backplane») d'un rack de fixation des modules. Le nombre de modules dépend bien entendu de la taille et du type de process à automatiser. Typiquement, un automate programmable comprend :

- un module d'alimentation fournissant les différentes tensions aux autres modules à travers le bus fond de panier,

- un module unité centrale qui comporte un logiciel embarqué («firmware») intégrant un système d'exploitation (OS) temps réel, et un programme d'application, ou programme utilisateur, contenant les instructions à exécuter par le logiciel embarqué pour effectuer les opérations d'automatisme souhaitées. Le module unité centrale comporte aussi généralement une connexion en face avant vers des outils de programmation de type ordinateur personnel PC,

- un ou plusieurs modules de communication vers des réseaux de communication (Ethernet, ...) ou des interfaces homme-machine (écran, clavier,...),

- des modules d'entrées/sorties E/S de divers types en fonction du ou des process à commander, tels que E/S numériques, analogiques, de comptage, etc. Ces modules E/S sont reliés à des capteurs et à des actionneurs participant à la gestion automatisée du process.

Les modules de comptage offrent généralement une fonction de mesure, notamment une fonction de mesure de fréquence. Cette mesure de fréquence consiste généralement à capturer un nombre d'impulsions dans un intervalle de temps d'échantillonnage prédéterminé et à délivrer ensuite une valeur correspondant au nombre d'impulsions reçues au cours d'une période de mesure également prédéterminée.

Selon la gamme de fréquence, la précision de la mesure varie lorsque la période de mesure varie. Pour une période de mesure courte et une gamme de fréquence élevée, la précision est très mauvaise, par exemple de 10% lorsque les impulsions sont reçues à une fréquence de 1000 Hz et que la période de mesure est de 10 millisecondes et la gamme de fréquence de 100 Hz. Inversement, lorsque la période de mesure est plus longue, par exemple de 10 secondes, et que la gamme de fréquence est faible, par exemple de l'ordre de 0,1 Hz, la précision sera très bonne,'de l'ordre de 0,01% lorsque les impulsions sont reçues en entrée à une fréquence de 1000 Hz.

Cependant, certains systèmes de régulation mis en oeuvre dans un automate programmable nécessitent une période de mesure très faible afin de pouvoir rafraichir la valeur de sortie fréquemment tout en ayant une grande précision de mesure, inférieure à 0,1%, sur une large plage de fréquence allant de 100Hz à 100kHz. L'invention vise à répondre à cet objectif. Les documents WO2006040699 et WO02099443 decrivent chacun appareil pour mesurer la fréquence d'un signal.

Le brut de l'invention est de proposer un dispositif et une méthode de mesure permettant de pouvoir délivrer une valeur de fréquence précise à quelques milli-Hertz près sur une période de mesure faible, par exemple de l'ordre de 10 millisecondes avec une précision de 0,02% sur une plage de fréquence allant de 100 Hz à 100 kHz.

Ce but est atteint par un procédé de mesure mis en oeuvre dans un dispositif de mesure recevant en entrée des impulsions successives à une fréquence déterminée, ledit dispositif comporte :

- une première horloge délivrant des impulsions à une première fréquence pour former des intervalles de temps fixes successifs,

- une seconde horloge délivrant des impulsions à une seconde fréquence,

- un premier compteur pour mesurer le nombre d'impulsions reçues en entrée du dispositif au cours de chaque intervalle de temps fixe défini par la première horloge,

- un second compteur destiné à mesurer le nombre d'impulsions de la seconde horloge, la valeur du second compteur étant initialisée à chaque impulsion reçue en entrée du dispositif et mémorisée à la fin de chaque intervalle de temps fixe,
caractérisé en ce que, pour un intervalle de temps fixe donné, le procédé comporte des étapes de :

- mémorisation de la valeur du second compteur et de la valeur du premier compteur à la fin de l'intervalle de temps fixe.

- détermination d'une période de mesure à partir de la durée de l'intervalle de temps fixe, de la valeur du second compteur mémorisée pour cet intervalle ainsi que de la valeur du second compteur mémorisée pour l'intervalle de temps fixe précédent,

- détermination de la fréquence à laquelle les impulsions sont reçues à partir de la valeur du premier compteur mémorisée et de la période de mesure déterminée.

Selon une particularité, la seconde fréquence est supérieure à la première fréquence.

Selon une première configuration, la période de mesure est une durée et est calculée à partir de la relation suivante :

$$P = T + \frac{(C20 - C21)}{N_{H2}}$$

dans laquelle P correspond à la période de mesure, T à la durée de l'intervalle de temps fixe, C21 au second compteur mémorisé pour l'intervalle de temps fixe donné, C20 au second compteur mémorisé pour l'intervalle de temps fixe précédent et- $N_{H2}$ au nombre d'impulsions délivrées par la seconde horloge pendant une seconde. La fréquence est alors déterminée à partir de la relation suivante :

$$F(Hz) = \frac{C10}{P}$$

ou de la relation

$$F(mHz) = \frac{C10}{P} \times 1000$$

dans lesquelles F correspond à la fréquence et C10 est la valeur du premier compteur (C1) mémorisée.

Selon une seconde configuration, la période de mesure est exprimée en nombre d'impulsions délivrées par la seconde horloge et est calculée à partir de la relation suivante:

$$P' = (N_{H2} \times T) + C20 - C21$$

dans laquelle P' correspond à la période de mesure, T à la durée de l'intervalle de temps fixe, C21 à la valeur du second compteur mémorisée pour l'intervalle de temps fixe (t2) donné, C20 à la valeur du second compteur mémorisée pour l'intervalle de temps fixe (T1) précédent et $N_{H2}$ le nombre d'impulsions délivrées par la seconde horloge pendant une seconde. La fréquence est alors déterminée à partir de la relation suivante :

$$F(Hz) = \frac{C10 \times N_{H2}}{P'}$$

ou de la relation suivante

$$F(mHz) = \frac{C10 \times N_{H2}}{P'} \times 1000$$

dans lesquelles F correspond à la fréquence et C10 est la valeur du premier compteur (C1) mémorisée.

Selon l'invention, la valeur du premier compteur est initialisée à la valeur 0 à chaque début d'un nouvel intervalle de temps fixe délivré par la première horloge ou à la valeur 1 si une impulsion a été reçue lors de la mémorisation du premier compteur à la fin de l'intervalle de temps fixe.

L'invention concerne également un dispositif de mesure, apte à mettre en oeuvre le procédé de mesure défini ci-dessus, ledit dispositif comportant:

- une première horloge délivrant des impulsions à une première fréquence, pour former des intervalles de temps fixes successifs,

- une seconde horloge délivrant des impulsions à une seconde fréquence,

- un premier compteur pour mesurer le nombre d'impulsions reçues en entrée du dispositif au cours de chaque intervalle de temps fixe défini par la première horloge,

- un second compteur destiné à mesurer le nombre d'impulsions de la seconde horloge, la valeur du second compteur étant initialisée à chaque impulsion reçue en entrée du dispositif et mémorisée à la fin de chaque intervalle de temps fixe,

- des moyens de mémorisation de la valeur du premier compteur à la fin d'un intervalle de temps fixe défini par la première horloge, d'une première valeur du second compteur pour cet intervalle de temps fixe et d'une seconde valeur du second compteur pour l'intervalle de temps fixe précédent,

- des moyens de détermination d'une période de mesure à partir de la durée de l'intervalle de temps fixe, de la première valeur du second compteur et de la seconde valeur du second compteur,

- des moyens de détermination de la fréquence à laquelle les impulsions sont reçues à partir de la valeur du premier compteur mémorisée et de la période de mesure déterminée.

D'autres caractéristiques et avantages vont apparaître dans la description détaillée qui suit en se référant à un mode de réalisation donné à titre d'exemple et représenté sur les dessins annexés définis ci-après :

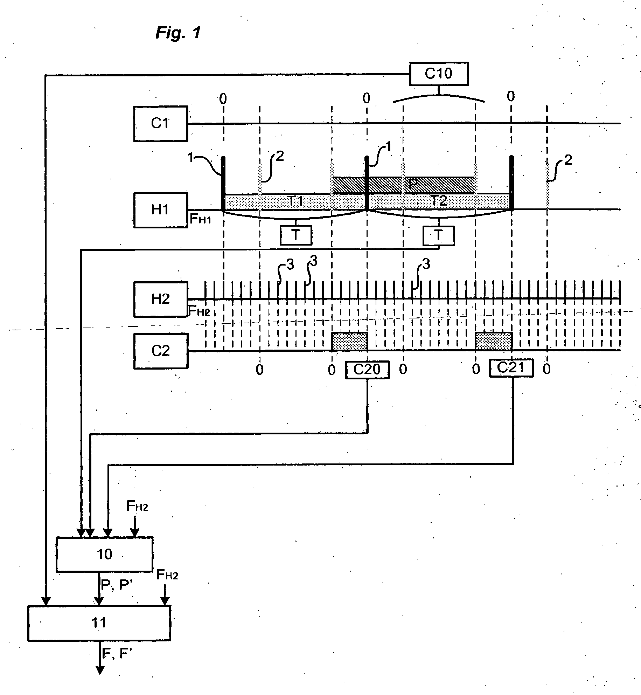

- la figure 1 représente un diagramme illustrant le principe de fonctionnement de l'invention.

Le procédé de mesure de l'invention est destiné à être mis en oeuvre dans un dispositif de mesure intégré par exemple dans un équipement d'automatisme tel qu'un module d'entréés/sorties de type comptage d'un automate programmable. Un module de comptage reçoit ainsi sur l'Une de ses entrées des impulsions 2 (figure 1) successives à une fréquence F déterminée. Le module de comptage, grâce au procédé et au dispositif de l'invention, calcule cette fréquence F et peut l'envoyer sur l'une de ses sorties, par exemple à destination d'un autre module d'entréés/sorties.

Le dispositif comporte des moyens de traitement, de mémorisation ainsi que des moyens logiciels non représentés sur la figure 1 permettant de mettre en oeuvre le procédé de l'invention.

En référence à la figure 1, le dispositif comporte tout d'abord une première horloge H1 destinée à délivrer des impulsions 1 à une première fréquence $F_{H1}$ de manière à former des intervalles de temps T fixes successifs. Chaque intervalle de temps T fixe dure par exemple 10 millisecondes. La fréquence F est par exemple calculée par les moyens de traitement du dispositif à la fin de chaque intervalle de temps T défini par la première horloge H1.

Le dispositif comporte une seconde horloge H2 délivrant des impulsions 3 à une seconde fréquence $F_{H2}$, la seconde fréquence $F_{H2}$ étant très supérieure à la première fréquence $F_{H1}$. Cette seconde horloge H2 est utilisée pour affiner la première horloge H1. Cette seconde horloge H2 fonctionne par exemple à une fréquence $F_{H2}$ de 4 MHz.

Les fréquences de la première horloge H1 et de la seconde horloge peuvent être fournies par dés oscillateurs à quartz ou par des subdivisions d'oscillateurs à quartz.

Le dispositif comporte également un premier compteur C1 destiné à comptabiliser le nombre d'impulsions 2 reçues en entrée du module au cours de chaque intervalle de temps T fixe défini par la première horloge H1. A la fin de chaque intervalle de temps T, le dispositif mémorise la valeur (par exemple C10 sur la figure 1) du premier compteur C1 et l'utilise pour calculer la fréquence des impulsions 2 reçues en entrée du module. Le premier compteur C1 est initialisé à la valeur 0 au début de chaque nouvel intervalle de temps T ou est initialisé à la valeur 1 si une impulsion est reçue en entrée du module alors que celui-ci est en cours de mémorisation de la valeur du premier compteur C1 à la fin de l'intervalle de temps T.

Le dispositif comporte un second compteur C2 destiné à comptabiliser le nombre d'impulsions 3 délivrées par la seconde horloge H2. La valeur du second compteur C2 est initialisée à chaque nouvelle impulsion 2 reçue en entrée du module et est mémorisée uniquement à la fin de chaque intervalle de temps T fixe défini par la première horloge H1. Par conséquent la valeur du second compteur C2 mémorisée correspond au nombre d'impulsions délivrées par la seconde horloge H2 entre la dernière impulsion 2 reçue en entrée et la fin de l'intervalle de temps T fixe défini par la première horloge H1. La valeur du second compteur C2 mémorisée à la fin de chaque intervalle de temps T est conservée au moins jusqu'à la fin de l'intervalle de temps fixe suivant, de sorte qu'à la fin de chaque intervalle T, le dispositif dispose dans ses moyens de mémorisation de la valeur du second compteur C21 associé à l'intervalle de temps fixe T2 qui vient de se terminer et la valeur du second compteur C20 de l'intervalle de temps fixe T1 précédent.

Le principe de l'invention consiste donc à utiliser les deux compteurs C1, C2 distincts définis ci-dessus. Le premier compteur C1 permet de compter le nombre d'impulsions 2 reçues en entrée du module au cours d'un intervalle de temps T fixe déterminé tandis que le deuxième compteur C2 permet d'effectuer un calcul précis d'une période de mesure P définie entre deux impulsions 2 reçues afin de pouvoir déterminer la fréquence F à laquelle sont reçues les impulsions.

Pour cela, le dispositif calcule d'abord la période de mesure P de la manière suivante (bloc 10 sur la figure 1):

$$P = T + \frac{(C20 - C21)}{N_{H2}}$$

Dans laquelle la période P calculée et l'intervalle de temps T sont exprimés en secondes. $N_{H2}$ correspond au nombre d'impulsions 3 délivrées par la seconde horloge H2 au cours d'une seconde. C21 et C20 sont les valeurs du second compteur respectivement pour l'intervalle de temps T2 qui vient de se terminer et pour l'intervalle de temps T1 précédent.

En considérant la période P définie précédemment, la valeur de la fréquence F à laquelle sont reçues les impulsions en entrée du module peut alors être exprimée en Hertz en valeur décimale ou en milli-Hertz en valeur absolue selon les relations suivantes (bloc 11 sur la figure 1) :

$$F(Hz) = \frac{C10}{P}$$

$$F(mHz) = \frac{C10}{P} \times 1000$$

dans lesquelles C10 correspond à la valeur du premier compteur C1 à la fin de l'intervalle de temps T qui vient de se terminer.

La fréquence de la seconde horloge H2 est par exemple égale à 4 MHz donnant une erreur maximale de 0,5µs (2x0,25µs) à la valeur de la période de mesure P calculée. Par exemple, pour un intervalle de temps T de 10ms, cette erreur sur la valeur de la période de mesure P garantit une erreur théorique maximale de 0,005% soit 50ppm de la valeur de la fréquence F calculée. Pour une fréquence de 100 Hz, l'erreur sera donc de 5mHz.

Selon une variante de réalisation, la fréquence peut également être calculée de la manière suivante (blocs 10 et 11 sur la figure 1):

$$P' = N + C20 - C21$$

$$F'(Hz) = \frac{C10 \times N_{H2}}{P'}$$

ou

5

$$F'(mHz) = \frac{C10 \times N_{H2}}{P'} \times 1000$$

Dans cette variante de réalisation, la période de mesure P' est exprimée en nombre d'impulsions. L'intervalle de temps T exprimé en secondes, défini par la première horloge H1, correspond alors à $N = N_{H2} \times T$ impulsions de la seconde horloge H2 si la seconde horloge oscille à une fréquence $F_{H2}$ délivrant $N_{H2}$ impulsions au cours d'une seconde. L'intervalle de temps T fixe défini par la première horloge H1 est par exemple de 10 millisecondes, ce qui correspond à 40.400 impulsions de la seconde horloge H2 si la seconde horloge oscille à une fréquence $F_{H2}$ de 4MHz.

Par ailleurs, la fréquence est déterminée en considérant que dans une seconde, la seconde horloge délivre $N_{H2}$ impulsions ce qui, pour le nombre d'impulsions de la période P', correspond à une durée de $P'/N_{H2}$. Au cours de cette durée, le module a reçu un nombre d'impulsions égal à la valeur C10 du compteur C1, ce qui correspond à une impulsion toutes les $(P'/N_{H2})/C10$. On obtient alors la fréquence F' de réception des impulsions définie ci-dessus.

Cette variante de réalisation permet de réaliser le calcul en valeur entière, c'est-à-dire en évitant les calculs flottants, tout en s'approchant de la précision théorique du principe précédent.

Par exemple, pour un intervalle de temps T de 10ms et une seconde horloge H2 oscillant à 4MHz, on obtient alors :

$$F'(mHz) = C10 \times \frac{(4.000.000.000)}{40000 + C20 - C21}$$

L'erreur apportée par le terme $\dfrac{(4.000.000.000)}{40000 + C20 - C21}$ est ainsi inférieure à 2/100.000. L'erreur globale de la mesure sera donc de l'ordre de 50ppm (selon le calcul fait précédemment pour le principe de base) auquel on ajoute une erreur de 0,2 ppm (liée au terme ci-dessus) et une erreur de 150ppm (liée au quartz utilisé).

Il est bien entendu que l'on peut, sans sortir du cadre de l'invention, imaginer d'autres variantes et perfectionnements de détail et même envisager l'emploi de moyens équivalents.

## Revendications

1. Procédé de mesure mis en oeuvre dans un dispositif de mesure recevant en entrée des impulsions (2) successives à une fréquence déterminée, ledit dispositif comporte :

   - une première horloge (H1) délivrant des impulsions (1) à une première fréquence ($F_{H1}$) pour former des intervalles de temps (T) fixes successifs,
   - une seconde horloge (H2) délivrant des impulsions à une seconde fréquence ($F_{H2}$),
   - un premier compteur (C1) pour mesurer le nombre d'impulsions reçues en entrée du dispositif au cours de chaque intervalle de temps (T) fixe défini par la première horloge (H1),
   - un second compteur (C2) destiné à mésurer le nombre d'impulsions de la seconde horloge (H2), la valeur du second compteur (C2) étant initialisée à chaque impulsion reçue en entrée du dispositif et mémorisée à la fin de chaque intervalle de temps (T) fixe,
   **caractérisé en ce que**, pour un intervalle de temps fixe (T2) donné, le procédé comporte des étapes de :
   - mémorisation de la valeur (C21) du second compteur (C2) et de la valeur (C10) du premier compteur (C1) à la fin de l'intervalle de temps (T2) fixe,
   - détermination d'une période de mesure (P, P') à partir de la durée de l'intervalle de temps (T2) fixe, de la valeur du second compteur (C21) mémorisée pour cette intervalle ainsi que de la valeur (C20) du second compteur (C2) mémorisée pour l'intervalle de temps (T1) fixe précédent,
   - détermination de la fréquence (F, F') à laquelle les impulsions (2) sont reçues à partir de la valeur (C10) du premier compteur mémorisée (C1) et de la période de mesure (P, P') déterminée.

2. Procédé selon la revendication 1, **caractérisé en ce que** la seconde fréquence ($F_{H2}$) est supérieure à la première fréquence ($F_{H1}$).

3. Procédé selon la revendication 1 ou 2, **caractérisé en ce que** la période de mesure (P) est une durée.

4. Procédé selon la revendication 3, **caractérisé en ce que** la période de mesure (P) est calculée à partir de la relation suivante :

$$P = T + \frac{(C20 - C21)}{N_{H2}}$$

dans laquelle P correspond à la période de mesure, T à la durée de l'intervalle de temps fixe, C21 au second compteur mémorisé pour l'intervalle de temps fixe donné, C20 au second compteur mémorisé pour l'intervalle de temps fixe précédent et $N_{H2}$ au nombre d'impulsions délivrées par la seconde horloge pendant une seconde.

5. Procédé selon la revendication 4, **caractérisé en ce que** la fréquence est déterminée à partir de la relation suivante :

$$F(Hz) = \frac{C10}{P}$$

ou de la relation

$$F(mHz) = \frac{C10}{P} x1000$$

dans lesquelles F correspond à la fréquence et C10 est la valeur du premier compteur (C1) mémorisée.

6. Procédé selon la revendication 1 ou 2, **caractérisé en ce que** la période de mesure (P') est exprimée en nombre d'impulsions délivrées par la seconde horloge (H2).

7. Procédé selon la revendication 6, **caractérisé en ce que** la période de mesure (P') est calculée à partir de la relation suivante :

$$P' = (N_{H2} xT) + C20 - C21$$

dans laquelle P' correspond à la période de mesure, T à la durée de l'intervalle de temps fixe, C21 à la valeur du second compteur mémorisée pour l'intervalle de temps fixe (t2) donné, C20 à la valeur du second compteur mémorisée pour l'intervalle de temps fixe (T1) précédent et $N_{H2}$ le nombre d'impulsions délivrées par la seconde horloge pendant une seconde.

8. Procédé selon la revendication 7, **caractérisé en ce que** la fréquence est déterminée à partir de la relation suivante :

$$F'(Hz) = \frac{C10 x N_{H2}}{P'}$$

ou de la relation suivante

$$F'(mHz) = \frac{C10 x N_{H2}}{P'} x1000$$

dans lesquelles F' correspond à la fréquence et C10 est la valeur du premier compteur (C1) mémorisée.

9. Procédé selon l'une des revendications 1 à 8, **caractérisé en ce que** la valeur du premier compteur (C1) est initialisée à la valeur 0 à chaque début d'un nouvel intervalle de temps (T) fixe délivré par la première horloge (H1) ou à la valeur 1 si une impulsion a été reçue lors de la mémorisation du premier compteur (C1) à la fin de l'intervalle de temps fixe (T).

10. Dispositif de mesure, apte à mettre en oeuvre le procédé de mesure défini dans l'une des revendications 1 à 9, ledit dispositif étant **caractérisé en ce qu'**il comporte :

   - une première horloge (H1) délivrant des impulsions à une première fréquence ($F_{H1}$) pour former des intervalles de temps (T) fixes successifs,
   - une seconde horloge (H2) délivrant des impulsions à une seconde fréquence ($F_{H2}$),
   - un premier compteur (C1) pour mesurer le nombre d'impulsions (2) reçues en entrée du dispositif au cours de chaque intervalle de temps fixe (T) défini par la première horloge (H1),
   - un second compteur (C2) destiné à mesurer le nombre d'impulsions de la seconde horloge (H2), la valeur du second compteur (C2) étant initialisée à chaque impulsion reçue en entrée du dispositif et mémorisée à la fin de chaque intervalle de temps fixe,
   - des moyens de mémorisation de la valeur (C10) du premier compteur (C1) à la fin d'un intervalle de temps fixe (T2) défini par la première horloge (H1), d'une première valeur (C21) du second compteur (2) pour cet intervalle de temps fixe (T2) et d'une seconde valeur (C20) du second compteur (2) pour l'intervalle de temps fixe (T1) précédent,
   - des moyens de détermination d'une période de mesure (P, P') à partir de la durée de l'intervalle de temps fixe, de la première valeur (C21) du second compteur (C2) et de la seconde valeur (C20) du second compteur (C2),
   - des moyens de détermination de la fréquence (F, F') à laquelle les impulsions (2) sont reçues à partir de la valeur (C10) du premier compteur (C1) mémorisée et de la période de mesure (P, P') déterminée.

11. Dispositif selon la revendication 10, **caractérisé en ce que** la seconde fréquence ($F_{H2}$) est supérieure à la première fréquence ($F_{H1}$).

12. Dispositif selon la revendication 10 ou 11, **caractérisé en ce que** la période de mesure (P) est une durée.

13. Dispositif selon la revendication 12, **caractérisé en ce que** la période de mesure (P) est calculée à partir de la relation suivante :

$$P = T + \frac{(C20 - C21)}{N_{H2}}$$

dans laquelle P correspond à la période de mesure, T à la durée de l'intervalle de temps fixe, C21 à la valeur du second compteur mémorisée pour un intervalle de temps fixe, C20 à la valeur du second compteur mémorisée pour l'intervalle de temps fixe précédent et $N_{H2}$ au nombre d'impulsions délivrées par la seconde horloge pendant une seconde.

14. Dispositif selon la revendication 13, **caractérisé en ce que** la fréquence est déterminée à partir de la relation suivante:

$$F(Hz) = \frac{C10}{P}$$

ou de la relation

$$F(mHz) = \frac{C10}{P} \times 1000$$

dans lesquelles F correspond à la fréquence et C10 est la valeur du premier compteur (C1).

**15.** Dispositif selon la revendication 10 ou 11, **caractérisé en ce que** la période de mesure (P') est exprimée en nombre d'impulsions délivrées par la seconde horloge (H2).

**16.** Dispositif selon la revendication 15, **caractérisé en ce que** la période de mesure (P') est calculée à partir de la relation suivante :

$$P' = (N_{H2} \, xT) + C20 - C21$$

dans laquelle P' correspond à la période de mesure, T à la durée de l'intervalle de temps fixe, C21 à la valeur du second compteur mémorisée pour un intervalle de temps fixe et C20 à la valeur du second compteur (C2) mémorisée pour l'intervalle de temps précédent et $N_{H2}$ au nombre d'impulsions délivrées par la seconde horloge pendant une seconde.

**17.** Dispositif selon la revendication 16, **caractérisé en ce que** la fréquence est déterminée à partir de la relation suivante:

$$F'(Hz) = \frac{C10 \, x N_{H2}}{P'}$$

ou

$$F'(mHz) = \frac{C10 \, x N_{H2}}{P'} \, x1000$$

dans lesquelles F' correspond à la fréquence et C10 est la valeur du premier compteur (C1).

**18.** Dispositif selon l'une des revendications 10 à 17, **caractérisé en ce que** le premier compteur (C1) est initialisé à la valeur 0 à chaque début d'un nouvel intervalle de temps (T) fixe délivré par la première horloge (H1) ou à la valeur 1 si une impulsion a été reçue lors de la mémorisation du premier compteur (C1).

**Patentansprüche**

**1.** Messverfahren, das in einer Messvorrichtung durchgeführt wird, die am Eingang aufeinanderfolgende Impulse (2) mit einer bestimmten Frequenz empfängt, wobei die Vorrichtung aufweist:

   - einen ersten Taktgeber (H1), der Impulse (1) mit einer ersten Frequenz ($F_{H1}$) liefert, um aufeinanderfolgende feste Zeitintervalle (T) zu formen,
   - einen zweiten Taktgeber (H2), der Impulse mit einer zweiten Frequenz ($F_{H2}$) liefert,
   - einen ersten Zähler (C1), um die Anzahl von während jedes vom ersten Taktgeber (H1) definierten festen Zeitintervalls (T) am Eingang der Vorrichtung empfangenen Impulsen zu messen,
   - einen zweiten Zähler (C2), der dazu bestimmt ist, die Anzahl von Impulsen des zweiten Taktgebers (H2) zu messen, wobei der Wert des zweiten Zählers (C2) bei jedem am Eingang der Vorrichtung empfangenen und am Ende jedes festen Zeitintervalls (T) gespeicherten Impuls zurückgestellt wird,
   **dadurch gekennzeichnet, dass** das Verfahren für ein gegebenes festes Zeitintervall (T2) die folgenden Schritte aufweist:
   - Speichern des Werts (C21) des zweiten Zählers (C2) und des Werts (C10) des ersten Zählers (C1) am Ende des festen Zeitintervalls (T2),
   - Bestimmen einer Messperiode (P, P'), ausgehend von der Dauer des festen Zeitintervalls (T2), des für dieses Intervall gespeicherten Werts (C21) des zweiten Zählers sowie des für das vorhergehende feste Zeitintervall (T1) gespeicherten Werts (C20) des zweiten Zählers (C2),
   - Bestimmen der Frequenz (F, F'), mit der die Impulse (2) empfangen werden, ausgehend vom gespeicherten Wert (C10) des ersten Zählers (C1) und von der bestimmten Messperiode (P, P').

**2.** Verfahren nach Anspruch 1, **dadurch gekennzeichnet, dass** die zweite Frequenz ($F_{H2}$) höher ist als die erste Frequenz ($F_{H1}$).

**3.** Verfahren nach Anspruch 1 oder 2, **dadurch gekennzeichnet, dass** die Messperiode (P) eine Dauer ist.

**4.** Verfahren nach Anspruch 3, **dadurch gekennzeichnet, dass** die Messperiode (P) ausgehend von der folgenden Beziehung berechnet wird:

$$P = T + \frac{(C20 - C21)}{N_{H2}}$$

wobei P der Messperiode, T der Dauer des festen Zeitintervalls, C21 dem für das gegebene feste Zeitintervall gespeicherten zweiten Zähler, C20 dem für das vorhergehende feste Zeitintervall gespeicherten zweiten Zähler und $N_{H2}$ der Anzahl von Impulsen entspricht, die vom zweiten Taktgeber während einer Sekunde geliefert werden.

**5.** Verfahren nach Anspruch 4, **dadurch gekennzeichnet, dass** die Frequenz ausgehend von der folgenden Beziehung:

$$F(Hz) = \frac{C10}{P}$$ oder der Beziehung $$F(mHz) = \frac{C10}{P} x1000$$ bestimmt wird, in denen F der Frequenz entspricht und C10 der gespeicherte Wert des ersten Zählers (C1) ist.

**6.** Verfahren nach Anspruch 1 oder 2, **dadurch gekennzeichnet, dass** die Messperiode (P') in Anzahl von vom zweiten Taktgeber (H2) gelieferten Impulsen ausgedrückt wird.

**7.** Verfahren nach Anspruch 6, **dadurch gekennzeichnet, dass** die Messperiode (P') ausgehend von der folgenden Beziehung berechnet wird:

$$P' = (N_{H2}xT) + C20 - C21$$

wobei P' der Messperiode, T der Dauer des festen Zeitintervalls, C21 dem gespeicherten Wert des zweiten Zählers für das gegebene feste Zeitintervall (t2), C20 dem gespeicherten Wert des zweiten Zählers für das vorhergehende feste Zeitintervall (T1) und $N_{H2}$ der Anzahl von Impulsen entspricht, die vom zweiten Taktgeber während einer Sekunde geliefert werden.

**8.** Verfahren nach Anspruch 7, **dadurch gekennzeichnet, dass** die Frequenz ausgehend von der folgenden Beziehung:

$$F'(Hz) = \frac{C10xN_{H2}}{P'}$$ oder der folgenden Beziehung $$F'(mHz) = \frac{C10xN_{H2}}{P'} x1000$$ bestimmt wird, in denen F' der Frequenz entspricht und C10 der gespeicherte Wert des ersten Zählers (C1) ist.

**9.** Verfahren nach einem der Ansprüche 1 bis 8, **dadurch gekennzeichnet, dass** der Wert des ersten Zählers (C1) bei jedem Beginn eines neuen festen Zeitintervalls (T), das vom ersten Taktgeber (H1) geliefert wird, auf den Wert 0 oder auf den Wert 1 zurückgestellt wird, wenn ein Impuls bei der Speicherung des ersten Zählers (C1) am Ende des festen Zeitintervalls (T) empfangen wurde.

**10.** Messvorrichtung, die das in einem der Ansprüche 1 bis 9 definierte Messverfahren durchführen kann, wobei die Vorrichtung **dadurch gekennzeichnet ist, dass** sie aufweist:

- einen ersten Taktgeber (H1), der Impulse mit einer ersten Frequenz ($F_{H1}$) liefert, um aufeinanderfolgende feste Zeitintervalle (T) zu formen,
- einen zweiten Taktgeber (H2), der Impulse mit einer zweiten Frequenz ($F_{H2}$) liefert,
- einen ersten Zähler (C1), um die Anzahl von am Eingang der Vorrichtung während jedes vom ersten Taktgeber (H1) definierten festen Zeitintervalls (T) empfangenen Impulsen (2) zu messen,
- einen zweiten Zähler (C2), der dazu bestimmt ist, die Anzahl von Impulsen des zweiten Taktgebers (H2) zu messen, wobei der Wert des zweiten Zählers (C2) bei jedem am Eingang der Vorrichtung empfangenen und am Ende jedes festen Zeitintervalls gespeicherten Impuls zurückgestellt wird,
- Einrichtungen zum Speichern des Werts (C10) des ersten Zählers (C1) am Ende eines vom ersten Taktgeber (H1) definierten festen Zeitintervalls (T2), eines ersten Werts (C21) des zweiten Zählers (C2) für dieses feste Zeitintervall (T2) und eines zweiten Werts (C20) des zweiten Zählers (2) für das vorhergehende feste Zeitintervall (T1),
- Einrichtungen zum Bestimmen einer Messperiode (P, P') ausgehend von der Dauer des festen Zeitintervalls, des ersten Werts (C21) des zweiten Zählers (C2) und des zweiten Werts (C20) des zweiten Zählers (C2),
- Einrichtungen zum Bestimmen der Frequenz (F, F'), mit der die Impulse (2) empfangen werden, ausgehend vom gespeicherten Wert (C10) des ersten Zählers (C1) und von der bestimmten Messperiode (P, P').

**11.** Vorrichtung nach Anspruch 10, **dadurch gekennzeichnet, dass** die zweite Frequenz ($F_{H2}$) höher ist als die erste Frequenz ($F_{H1}$).

**12.** Vorrichtung nach Anspruch 10 oder 11, **dadurch gekennzeichnet, dass** die Messperiode (P) eine Dauer ist.

**13.** Vorrichtung nach Anspruch 12, **dadurch gekennzeichnet, dass** die Messperiode (P) ausgehend von der folgenden Beziehung berechnet wird:

$$P = T + \frac{(C20 - C21)}{N_{H2}}$$

wobei P der Messperiode, T der Dauer des festen Zeitintervalls, C21 dem gespeicherten Wert des zweiten Zählers für ein festes Zeitintervall, C20 dem gespeicherten Wert des zweiten Zählers für das vorhergehende feste Zeitintervall und $N_{H2}$ der Anzahl von Impulsen entspricht, die vom zweiten Taktgeber während einer Sekunde geliefert werden.

**14.** Vorrichtung nach Anspruch 13, **dadurch gekennzeichnet, dass** die Frequenz ausgehend von der folgenden Beziehung:

$$F(Hz) = \frac{C10}{P} \quad \text{oder der Beziehung} \quad F(mHz) = \frac{C10}{P} \times 1000$$

bestimmt wird, in denen F der Frequenz entspricht und C10 der Wert des ersten Zählers (C1) ist.

**15.** Vorrichtung nach Anspruch 10 oder 11, **dadurch gekennzeichnet, dass** die Messperiode (P') in Anzahl von vom zweiten Taktgeber (H2) gelieferten Impulsen ausgedrückt wird.

**16.** Vorrichtung nach Anspruch 15, **dadurch gekennzeichnet, dass** die Messperiode (P') ausgehend von der folgenden Beziehung berechnet wird:

$$P' = (N_{H2} \times T) + C20 - C21$$

wobei P' der Messperiode, T der Dauer des festen Zeitintervalls, C21 dem gespeicherten Wert des zweiten Zählers für ein festes Zeitintervall und C20 dem gespeicherten Wert des zweiten Zählers (C2) für das vorhergehende Zeitintervall und $N_{H2}$ der Anzahl von Impulsen entspricht, die vom zweiten Taktgeber während einer Sekunde geliefert werden.

**17.** Vorrichtung nach Anspruch 16, **dadurch gekennzeichnet, dass** die Frequenz ausgehend von der folgenden Beziehung:

$$F'(Hz) = \frac{C10 \times N_{H2}}{P'} \quad \text{oder} \quad F'(mHz) = \frac{C10 \times N_{H2}}{P'} \times 1000$$

bestimmt wird, in denen F' der Frequenz entspricht und C10 der Wert des ersten Zählers (C1) ist.

18. Vorrichtung nach einem der Ansprüche 10 bis 17, **dadurch gekennzeichnet, dass** der erste Zähler (C1) zu jedem Beginn eines vom ersten Taktgeber (H1) gelieferten neuen Zeitintervalls (T) auf den Wert 0 oder auf den Wert 1 zurückgestellt wird, wenn ein Impuls während der Speicherung des ersten Zählers (C1) empfangen wurde.

**Claims**

1. Measurement method implemented in a measurement device receiving as input successive pulses (2) at a given frequency, said device comprising:

   - a first clock (H1) delivering pulses (1) at a first frequency ($F_{H1}$) so as to form successive fixed time intervals (T),
   - a second clock (H2) delivering pulses at a second frequency ($F_{H2}$),
   - a first counter (C1) for measuring the number of pulses received as input of the device during each fixed time interval (T) defined by the first clock (H1),
   - a second counter (C2) designed to measure the number of pulses from the second clock (H2), the value of the second counter (C2) being reset upon each pulse received as input of the device and stored at the end of each fixed time interval (T),
   **characterized in that**, for a given fixed time interval (T2), the method comprises steps for:
   - storing the value (C21) of the second counter (C2) and the value (C10) of the first counter (C1) at the end of the fixed time interval (T2),
   - determining a measurement period (P, P') based on the duration of the fixed time interval (T2), on the value of the second counter (C21) stored for this interval together with the value (C20) of the second counter (C2) stored for the preceding fixed time interval (T1),
   - determining the frequency (F, F') at which the pulses (2) are received based on the stored value (C10) of the first counter (C1) and on the determined measurement period (P, P').

2. Method according to Claim 1, **characterized in that** the second frequency ($F_{H2}$) is higher than the first frequency ($F_{H1}$).

3. Method according to either of Claims 1 and 2, **characterized in that** the measurement period (P) is a period of time.

4. Method according to Claim 3, **characterized in that** the measurement period (P) is calculated from the following equation:

$$P = T + \frac{(C20 - C21)}{N_{H2}}$$

in which P corresponds to the measurement period, T to the duration of the fixed time interval, C21 to the second counter stored for the fixed time interval, C20 to the second counter stored for the preceding fixed time interval and $N_{H2}$ to the number of pulses delivered by the second clock during one second.

5. Method according to Claim 4, **characterized in that** the frequency is determined from the following equation:

$$F(Hz) = \frac{C10}{P}$$

or from the equation:

$$F(mHz) = \frac{C10 \times 1000}{P}$$

in which F corresponds to the frequency and C10 is the stored value of the first counter (C1).

6. Method according to either of Claims 1 and 2, **characterized in that** the measurement period (P') is expressed as a number of pulses delivered by the second clock (H2).

7. Method according to Claim 6, **characterized in that** the measurement period (P') is calculated from the following equation:

$$P' = (N_{H2} \times T) + C20 - C21$$

in which P' corresponds to the measurement period, T to the duration of the fixed time interval, C21 to the value of the second counter stored for the given fixed time interval (t2), C20 to the value of the second counter stored for the preceding fixed time interval (T1) and $N_{H2}$ the number of pulses delivered by the second clock during one second.

8. Method according to Claim 7, **characterized in that** the frequency is determined from the following equation:

$$F'(Hz) = \frac{C10 \times N_{H2}}{P'}$$

or from the following equation:

$$F'(mHz) = \frac{C10 \times N_{H2}}{P'} \times 1000$$

in which F' corresponds to the frequency and C10 is the stored value of the first counter (C1).

9. Method according to one of Claims 1 to 8, **characterized in that** the value of the first counter (C1) is reset to the value 0 at each start of a new fixed time interval (T) delivered by the first clock (H1) or to the value 1 if a pulse has been received when the first counter (C1) was stored at the end of the fixed time interval (T).

10. Measurement device capable of implementing the measurement method defined in one of Claims 1 to 9, said device being **characterized in that** it comprises:

- a first clock (H1) delivering pulses (1) at a first frequency ($F_{H1}$) so as to form successive fixed time intervals (T),
- a second clock (H2) delivering pulses at a second frequency ($F_{H2}$),
- a first counter (C1) for measuring the number of pulses received as input of the device during each fixed time interval (T) defined by the first clock (H1),
- a second counter (C2) designed to measure the number of pulses from the second clock (H2), the value of the second counter (C2) being reset upon each pulse received as input of the device and stored at the end of each fixed time interval,
- means for storing the value (C10) of the first counter (C1) at the end of a fixed time interval (T2) defined by the first clock (H1), a first value (C21) of the second counter (2) for this fixed time interval (T2) and a second value (C20) of the second counter (2) for the preceding fixed time interval (T1),
- means for determining a measurement period (P, P') based on the duration of the fixed time interval, on the first value (C21) of the second counter (C2) and on the second value (C20) of the second counter (C2),
- means for determining the frequency (F, F') at which the pulses (2) are received based on the stored value (C10) of the first counter (C1) and on the determined measurement period (P, P').

11. Device according to Claim 10, **characterized in that** the second frequency ($F_{H2}$) is higher than the first frequency ($F_{H1}$).

12. Device according to either of Claims 10 and 11, **characterized in that** the measurement period (P) is a period of time.

13. Device according to Claim 12, **characterized in that** the measurement period (P) is calculated from the following equation:

$$P = T + \frac{(C20 - C21)}{N_{H2}}$$

in which P corresponds to the measurement period, T to the duration of the fixed time interval, C21 to the value of the second counter stored for a fixed time interval, C20 to the value of the second counter stored for the preceding time interval and $N_{H2}$ to the number of pulses delivered by the second clock during one second.

14. Device according to Claim 13, **characterized in that** the frequency is determined from the following equation:

$$F(Hz) = \frac{C10}{P}$$

or from the equation:

$$F(mHz) = \frac{C10}{P} \times 1000$$

in which F corresponds to the frequency and C10 is the value of the first counter (C1).

15. Device according to either of Claims 10 and 11, **characterized in that** the measurement period (P') is expressed as a number of pulses delivered by the second clock (H2).

16. Device according to Claim 15, **characterized in that** the measurement period (P') is calculated from the following equation:

$$P' = (N_{H2} \times T) + C20 - C21$$

in which P' corresponds to the measurement period, T to the duration of the fixed time interval, C21 to the value of the second counter stored for a fixed time interval and C20 to the value of the second counter (C2) stored for the preceding time interval and $N_{H2}$ to the number of pulses delivered by the second clock during one second.

17. Device according to Claim 16, **characterized in that** the frequency is determined from the following equation:

$$F'(Hz) = \frac{C10 \times N_{H2}}{P'}$$

or

$$F'(mHz) = \frac{C10 \times N_{H2}}{P'} \times 1000$$

in which F' corresponds to the frequency and C10 is the value of the first counter (C1).

18. Device according to one of Claims 10 to 17, **characterized in that** the first counter (C1) is reset to the value 0 at each start of a new fixed time interval (T) delivered by the first clock (H1) or to the value 1 if a pulse has been received when the first counter (C1) was stored.

**Fig. 1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006040699 A
- WO 02099443 A